# EUROPÄISCHE PATENTSCHRIFT

(11) **EP 2 025 209 B1**
(45) Veröffentlichungstag und Bekanntmachung des Hinweises auf die Patenterteilung: **27.03.2013**
(21) Anmeldenummer: 07718466.1
(22) Anmeldetag: 25.05.2007
(51) Int. Cl.: H05K 1/05

(54) **VERFAHREN ZUR HERSTELLUNG EINES SCHALTUNGSTRÄGERS**
METHOD FOR MANUFACTURING A CIRCUIT CARRIER
PROCÉDÉ DE FABRICATION D'UN SUPPORT DE CIRCUIT

(30) Priorität: 07.06.2006 AT 9722006
(43) Veröffentlichungstag der Anmeldung: 18.02.2009
(73) Patentinhaber: Ab Mikroelektronik Gesellschaft Mit Beschränkter Haftung, 5013 Salzburg (AT)
(72) Erfinder: HAEGELE, Bernd, 84529 Tittmoning (DE)
(74) Vertreter: Gangl, Markus
(86) Internationale Anmeldenummer: PCT/AT2007/000255
(87) Internationale Veröffentlichungsnummer: WO 2007/140495

(56) Entgegenhaltungen:
- EP-A- 0 099 258
- EP-A- 0 374 452
- WO-A-97/13274
- DE-A1- 2 556 826
- DE-A1- 3 916 398
- DE-A1- 4 330 713
- US-A- 3 202 591
- US-A- 3 821 611
- US-A- 4 141 055
- US-A- 4 491 622

## Beschreibung

Die Erfindung betrifft einen Schaltungsträger sowie ein Verfahren zur Herstellung eines Schaltungsträgers mit einer metallischen Trägerschicht, auf der zumindest bereichsweise eine dielektrische Schicht angeordnet ist, wobei die metallische Trägerschicht wenigstens bereichsweise gekrümmt ausgebildet ist und wobei wenigstens eine erste Leiterbahn auf die dielektrische Schicht aufgebracht wird, wobei an wenigstens einer Stelle ein dielektrisches Material auf die wenigstens eine erste Leiterbahn aufgebracht wird und wobei wenigstens eine zweite Leiterbahn so auf die dielektrische Schicht aufgebracht wird, dass sie an der wenigstens einen Stelle, die wenigstens eine erste Leiterbahn in Draufsicht auf den Schaltungsträger kreuzend, über das dielektrische Material verläuft.

Derartige Schaltungsträger werden vorrangig im Bereich der Leistungselektronik, insbesondere im Bereich von Hochtemperaturanwendungen wie dem Motorraum oder Antriebsstrang von Kraftfahrzeugen, eingesetzt.

Der Betrieb jeder elektrischer bzw. elektronischer Schaltung ist mit der Entstehung von Abwärme verbunden, welche, um einer Beeinträchtigung des Betriebs bzw. einer Zerstörung der Schaltung vorzubeugen, so schnell wie möglich abgeführt werden muss. Insbesondere Leistungselektronik zeichnet sich im Betrieb durch eine sehr große Menge von Abwärme aus. Erschwerend kommt bei Hochtemperaturanwendungen noch die relativ hohe Umgebungstemperatur von weit über 100 °C (beispielsweise ca. 150 °C in gewissen Bereichen des Motorraums von Kraftfahrzeugen) hinzu. Um eine möglichst rasche Ableitung der Abwärme zu erreichen, werden die elektrischen bzw. elektronischen Schaltungen auf Schaitungsträgem angebracht, deren metallisches Trägermaterial als Kühlkörper für die Schaltung fungieren kann.

Die Schicht aus dielektrischen Material, welche meist sehr viel dünner ausgebildet ist als jene aus metallischem Material, dient vor allem dazu, die einzelnen Leiterbahnen, welche auf der Schicht aus dielektrischem Material angeordnet sind, vom metallischen Trägermaterial elektrisch zu isolieren. Daneben kann ein dielektrisches Material gewählt werden, welches sich durch einen sehr niedrigen Wärmeübergangswiderstand auszeichnet, sodass die Abwärme von elektrischen bzw. elektronischen Bauteilen, welche auf der Schicht aus dielektrischem Material angeordnet sind, so schnell wie möglich über das metallische Trägerelement abgeführt werden kann.

Bei bisher bekannten Schaltungsträgern (z.B. DE 25 56 826) fehlte zudem die Möglichkeit komplexere Schaltungsaufbauten zu realisieren.

Erfindungsgemäß ist daher vorgesehen, dass die Herstellung eines derartigen Schaltungsträgers derart erfolgt, dass das dielektrische Material für die dielektrische Schicht durch thermisches Spritzen aufgebracht wird und dass Leiterbahnen und/oder elektrische bzw. elektronische Bauteile im gekrümtnten Bereich angebracht werden.

Durch die die konstruktive Einsetzbarkeit erhöhende, gekrümmte Ausbildung kann auf im jeweiligen Anwendungsfall vorliegende geometrische Gegebenheiten besonders Rücksicht genommen werden.

Insbesondere das thermische Spritzen eignet sich besonders für die Herstellung eines derartigen Schaltungsträgers, da es für das Aufspritzen des dielektrischen Materials gleichgültig ist, ob die metallische Trägerschicht gekrümmt oder eben ausgebildet ist.

Erfingdungsgemäß sind auf einem derartigen Schaltungsträger auf der dielektrischen Schicht auch im gekrümmten Bereich, Leiterbahnen und/oder elektrische bzw. elektronische Bauteile angebracht.

Die dielektrische Schicht kann ebenso wie in den vorstehend beschriebenen Ausführungsformen ein Keramikmaterial, vorzugsweise Aluminumoxid (Al₂O₃) oder Aluminiumnitrid (AIN) sein.

Prinzipiell kann das erfindungsgemäße Verfahren bei allen Arten von thermischen Spritzverfahren eingesetzt werden. im Stand der Technik sind beispielsweise das Plasmaspritzen und Flammspritzen bekannt. Die deutsche Norm DIN 32530 unterteilt die unter dem Begriff "thermisches Spritzen" zusammengefassten Spritzverfahren in genauer Weise. Beispielhaft sei das Plasmaspritzverfahren im Folgenden kurz beschrieben.

Beim Plasmaspritzen wird der pulverförmige Spritzzusatz in oder außerhalb einer Plasmakanone durch einen Plasmastrahl geschmolzen und auf die Werkstückoberfläche geschleudert. Das Plasma wird durch einen Lichtbogen erzeugt, der in einem Gas (Plasmagas) brennt, welches dabei dissoziiert und ionisiert wird. Die ionisierten Gasteilchen erreichen eine hohe Ausströmgeschwindigkeit und geben bei der Rekombination ihre Wärmeenergie an die Spritzpartikel ab.

Bei dem vorliegenden Verfahren kann das Siegelmaterial an sich getrennt vom dielektrischen Material in den thermischen Strahl (Plasmastrahl) eingebracht werden. Besonders bevorzugt ist jedoch eine Ausführungsform der Erfindung, bei welcher das Siegelmaterial dem dielektrischen Material vor dem Aufspritzen beigemengt wird. Hierdurch kann einerseits eine gute Vermengung des Siegelmaterials und des dielektrischen Materials sichergestellt werden. Andererseits kann die Zuführung des aufzuspritzenden Materials über eine einzige Einbringungsvorrichtung erfolgen.

Als dielektrisches Material kann beispielsweise ein Keramikmaterial. vorzugsweise Aluminiumoxid (Al₂O₃) oder Aluminiumnitrit (AIN) verwendet werden.

Als Siegelmaterial eignen sich besonders Gläser. Beispielsweise kann vorgesehen sein, dass das verwendete Glas aus Dibismuttrioxid, Aluminiumoxid, Siliziumdioxid oder Dibortrioxid oder einem Gemisch aus zwei oder mehreren dieser Komponenten besteht. In einem möglichen Ausführungsbeispiel kann vorgesehen sein, dass das verwendete Glas aus 55 % Dibismuttrioxid, 21 % Aluminiumoxid, 14 % Siliziumdioxid und 10 % Dibortrioxid besteht. Geeignete Gläser können zum Beispiel von der Ferro Corporation, 1000 Lakeside Avenue, Cleveland, Ohio 44114-7000, USA (www.ferro.com) bezogen werden.

Das gewünschte Versiegeln der Poren kann mit einer Menge an Siegelmaterial von etwa 5 % bis 30 % der Gesamtmenge von dielektrischem Material und Siegelmaterial erreicht werden.

Wird als thermisches Spritzverfahren das Plasmaspritzen gewählt, sollte darauf geachtet werden, dass das meist in Pulverform vorliegende Siegelmaterial mit einer solchen Komgröße und Schmelztemperatur gewählt wird, dass das Siegelmaterial bis zur notwendigen Spritztemperatur, beispielsweise 2100 °C verbrennungsfrei auf das metallische Trägermaterial gespritzt werden kann. So können beispielsweise Al₂O₃ Pulver mit Paffikeigrößen von 5µm bis 60µm (typisch -22,5µm / +5,6µm) und einer Schmelztemperatur von 2050°C verwendet.

Es hat sich herausgestellt, dass es für die Befestigung der Leiterbahnen und der elektrischen bzw. elektronischen Bauteile wünschenswert ist, wenn die Oberfläche der Schicht aus dielektrischem Material im Wesentlichen frei von Siegelmaterial ist. Beim Stand der Technik musste hierfür die zuvor aufgestrichene Harzschicht in einem gesonderten Arbeitsgang entfernt werden. Das erfindungsgemäße Verfahren weist den weiteren Vorteil auf, dass die Spritztemperatur und der Spritzdruck derart gewählt werden können, dass die Oberfläche der Schicht aus dielektrischem Material bereits nach Beendigung des Spritzvorganges ohne weitere Arbeitsschritte im Wesentlichen frei von Siegelmaterial ist.

### Beispiel:

Im Spritzprozess erreicht der Plasmastrahl unmittelbar am Düsenaustritt eine sehr hohe Geschwindigkeit von typisch ca. 349m/s. Die Temperaturen liegen dabei oberhalb von 22.000°C. Die Geschwindigkeit ist dabei abhängig von der Partikelgröße und der Gasgeschwindigkeit. Die Temperaturen beim Auftreffen auf das Substrat liegen noch zwischen 2.500°C und 3.000°C wobei die Partikelgeschwindigkeiten je nach Partikelgröße noch zwischen 115m/s bis 220m/s betragen kann.

Weitere Vorteile und Einzelheiten der einzelnen Ausführungsformen der Erfindung ergeben sich anhand der Figuren sowie der dazugehörigen Figurenbeschreibungen. Dabei zeigen:
- Fig. 1: schematisch eine Vorrichtung zur Durchführung eines erfindungsgemäßen Verfahrens,
- Fig. 2a, 2b, 2c: einen mit dem erfindungsgemäßen Verfahren hergestellten Schaltungsträger in Draufsicht, Seitendarstellung und in einer Detailansicht und
- Fig. 3: den Einsatz eines erfindungsgemäßen Schaltungsträgers in einer Wasserpumpe.

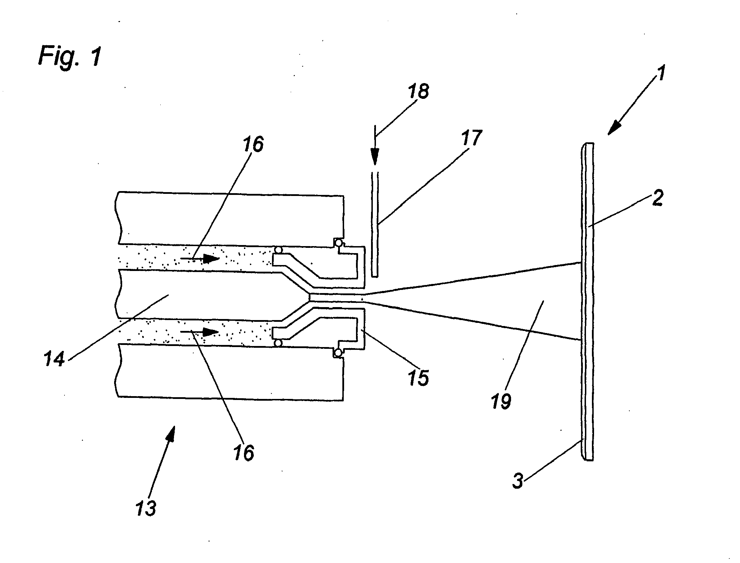

Fig. 1 zeigt das thermische Aufspritzen einer Schicht 3 aus dielektrischem Material auf eine Schicht 2 aus metallischem Trägermaterial eines Schaltungsträgers 1. Schematisch dargestellt ist eine Plasmakanone 13 mit einer Kathode 14 und einer Anode 15. Die Pfeile 16 deuten die Zuführung von Plasmagas an. Durch eine Hochfrequenzzündung kommt es zur Ausbildung eines Lichtbogens zwischen der Kathode 14 und der Anode 15, was zur Ionisierung des Plasmagases führt. Das so entstandene Plasma verlässt die Brenndüse mit hohen Geschwindigkeiten (ca. 300 bis 700 m/s) und mit Temperaturen von ca. 15000 bis 20000 °C. Über eine Einbringungsvorrichtung 17 wird das auf die Schicht 2 aufzubringende Material (dargestellt durch den Pfeil 18) in den Plasmastrahl eingebracht, wo es durch diesen aufgeschmolzen und auf eine hohe Geschwindigkeit beschleunigt wird. Das aufgeschmolzene Material trifft mit einer hohen Geschwindigkeit auf die metallische Trägerschicht 2 auf (Strahl 19) und lagert sich dort als Schicht 3 aus dielektrischem Material ab. Bei einer bevorzugten Ausführungsform wird ein Gemenge aus dem Siegelmaterial und dem dielektrischen Material gemeinsam über die Einbringungsvorrichtung 17 in den Plasmastrahl eingebracht.

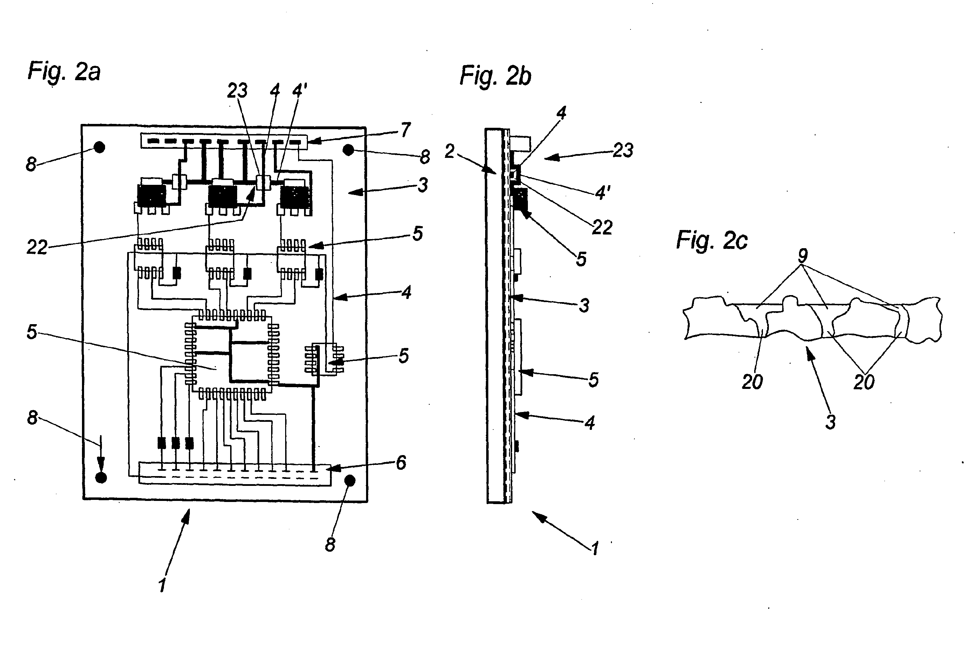

Fig. 2a zeigt in Draufsicht beispielhaft einen Schaltungsträger 1 an dessen Schicht 3 aus dielektrischem Material Leiterbahnen 4 sowie elektrische bzw. elektronische Bauteile 5 angebracht sind. In diesem Ausführungsbeispiel besteht die metallische Trägerschicht 2 aus Aluminium, welche vor dem thermischen Bespritzen mittels Sandstrahltechnik gereinigt und angeraut wurde. Die Schicht 3 überdeckt die metallische Trägerschicht 2 vollflächig. An den vier Ecken der metallischen Trägerschicht 2 sind Bohrungen 8 angeordnet, über die der Schaltungsträger 1 später verschraubt werden kann. In Fig. 2a sind weiters eine vierundzwanzigpolige Steckerleiste 6 sowie eine neunpolige Steckerleiste 7 erkennbar. Bei den dargestellten elektrischen bzw. elektronischen Bauteilen 5 handelt es sich um einen Mikrokontrolier, Regler, Treiberschaltkreise, Leistungstransistoren und Widerstände. An der Stelle 22 kreuzen sich zwei Leiterbahnen 4, 4', wobei zwischen den sich kreuzenden Leiterbahnen 4, 4' ein dielektrisches Material 22 angeordnet ist.

Die Leiterbahnen 4 wurden nach dem thermischen Aufspritzen der Schicht 3 aus dielektrischem Material auf diese aufgedruckt und anschließend bei Temperaturen zwischen 400 °C und 530 °C gesintert. Auf die gedruckten Leiterbahnen 4 wurde anschließend mittels Schablonendruck eine Lotpastenschicht aufgetragen, in die dann die elektrischen bzw. elektronischen Bauteile 5 hineinbestückt wurden.

Die bestückten Bauteile 5 und die Steckerleisten 6, 7 wurden gleichzeitig auf dem Schaltungsträger 1 verlötet.

Um eine ideale Abfuhr der Abwärme der elektrischen bzw. elektronischen Bauteile 5 zu erzielen, wurden alle elektrischen bzw. elektronischen Bauteile 5 unmittelbar, das heißt ohne Zwischenträger, auf dem Schaltungsträger 1 (auf dessen Schicht 3) montiert.

In Fig. 2b ist der Schichtaufbau eines erfindungsgemäßen Schaltungsträgers 1 dargestellt. Diese Darstellung ist selbstverständlich nicht maßstabsgerecht. Beispielsweise kann die Dicke der metallischen Trägerschicht 2 bis zu 10 mm (typisch 1-5 mm) betragen, während die Schicht 3 aus dielektrischem Material üblicherweise eine Dicke von 30 µm bis 70 µm aufweist.

Fig. 2c zeigt eine Detailsicht des in den Fig. 2a und 2b dargestellten Schaltungsträgers 1 im Bereich der Schicht 3 aus dielektrischem Material. Erkennbar sind in der Schicht 3 aus dielektrischem Material angeordnete Poren 20, welche durch Siegelmaterial 9 versiegelt sind. Erkennbar ist weiters, dass die Oberfläche der Schicht 3 aus dielektrischem Material außerhalb des Bereichs der Poren 20 im Wesentlichen frei vom Siegelmaterial 9 ist.

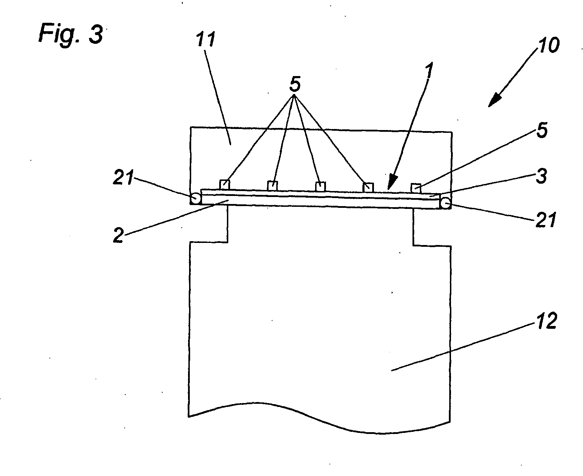

Fig. 3 zeigt eine spezielle Anwendung eines erfindungsgemäßen Schaltungsträgers 1 in einer Wasserpumpe 10. Die Wasserpumpe 10 weist dabei eine erste Teilkammer 11 und eine zweite Teilkammer 12 auf. Der Schaltungsträger 1 ist als Strukturelement (in diesem Fall als Trennwand) zwischen den beiden Teilkammern 11, 12 der Wasserpumpe 10 angeordnet. Die Anordnung ist so gewählt, dass die metallische Trägerschicht 2 zur zweiten Teilkammer 12 zeigt, während die Schicht 3 aus dielektrischem Material mit den daran angeordneten elektrischen bzw. elektronischen Bauteilen 5 in die erste Teilkammer 11 ragt. Im Betrieb der Wasserpumpe 10 kann die metallische Trägerschicht 2 vom in der Teilkammer 12 befindlichen Wasser überströmt werden, was die Kühlung der elektrischen bzw. elektronischen Bauelemente 5 erheblich verbessert. Um zu verhindern, dass Wasser von der zweiten Teilkammer 12 in die erste Teilkammer 1 eindringt sind wasserdichte Isolierungen 21 vorgesehen.

## Patentansprüche

1. Verfahren zur Herstellung eines Schaltungsträgers (1) mit einer metallischen Trägerschicht (2), auf der zumindest bereichsweise eine dielektrische Schicht (3) angeordnet ist, wobei die metallische Trägerschicht (2) wenigstens bereichsweise gekrümmt ausgebildet ist und wobei wenigstens eine erste Leiterbahn (4) auf die dielektrische Schicht (3) aufgebracht wird, wobei an wenigstens einer Stelle (22) ein dielektrisches Material (23) auf die wenigstens eine erste Leiterbahn (4) aufgebracht wird und wobei wenigstens eine zweite Leiterbahn (4') so auf die dielektrische Schicht (3) aufgebracht wird, dass sie an der wenigstens einen Stelle (22), die wenigstens eine erste Leiterbahn (4) in Draufsicht auf den Schaltungsträger (1) kreuzend, über das dielektrische Material (23) verläuft, **dadurch gekennzeichnet, dass** das dielektrische Material für die dielektrische Schicht (3) durch thermisches Spritzen aufgebracht wird und dass Leiterbahnen (4, 4') und/oder elektrische bzw. elektronische Bauteile (5) im gekrümmten Bereich angebracht werden.

2. Schaltungsträger (1), hergestellt in einem Verfahren nach Anspruch 1, mit einer metallischen Trägerschicht (2), auf der zumindest bereichsweise eine dielektrische Schicht (3) angeordnet ist, wobei die metallische Trägerschicht (2) wenigstens bereichsweise gekrümmt ausgebildet ist und wobei auf der dielektrischen Schicht (3) Leiterbahnen (4, 4') angeordnet sind, wobei der Schaltungsträger (1) wenigstens eine Stelle (22) aufweist, an der sich in Draufsicht (22) auf den Schaltungsträger (1) zwei Leiterbahnen (4, 4') kreuzen, wobei zwischen den sich kreuzenden Leiterbahnen (4, 4') ein dielektrisches Material (23) - insbesondere ein Glas - angeordnet ist, **dadurch gekennzeichnet, dass** die elektrische Schicht (3) thermisch aufgespritzt ist und dass im gekrümmten Bereich Leiterbahnen (4, 4') und/oder elektrische bzw. elektronische Bauteile (5) angebracht sind.

3. Schaltungsträger nach Anspruch 2, **dadurch gekennzeichnet, dass** die dielektrische Schicht (3) ein Keramikmaterial, vorzugsweise Aluminiumoxid (Al₂O₃) oder Aluminiumnitrid (AIN) ist.

## Claims

1. A process for the production of a circuit carrier (1) comprising a metallic carrier layer (2) on which a dielectric layer (3) is at least region-wise arranged, wherein the metallic carrier layer (2) is at least region-wise of a curved configuration and wherein at least one first conductor track (4) is applied to the dielectric layer (3), wherein at at least one location (22) a dielectric material (23) is applied to the at least one first conductor track (4) and wherein at least one second conductor track (4') is so applied to the dielectric layer (3) that at the at least one location (22) it extends over the dielectric material (23), crossing the at least one first conductor track (4) in a plan view on to the circuit carrier (1), **characterised in that** the dielectric material for the dielectric layer (3) is applied by thermal spraying and conductor tracks (4, 4') and/or electric or electronic components (5) are mounted in the curved region.

2. A circuit carrier (1) produced by a process according to claim 1 comprising a metallic carrier layer (2) on which a dielectric layer (3) is at least region-wise arranged, wherein the metallic carrier layer (2) is at least region-wise of a curved configuration and wherein conductor tracks (4, 4') are arranged on the dielectric layer (3), wherein the circuit carrier (1) has at least one location (22) at which two conductor tracks (4, 4') cross in plan view (22) on to the circuit carrier (1), wherein a dielectric material (23) - in particular a glass - is arranged between the mutually crossing conductor tracks (4, 4'), **characterised in that** the electric layer (3) is thermally sprayed on and conductor tracks (4, 4') and/or electric or electronic components (5) are mounted in the curved region.

3. A circuit carrier according to claim 2 **characterised in that** the dielectric layer (3) is a ceramic material, preferably aluminium oxide (Al₂O₃) or aluminium nitride (AIN).

## Revendications

1. Procédé de fabrication d'un support de circuit (1) avec une couche de support métallique (2) sur laquelle une couche diélectrique (3) est déposée sur certaines zones, la couche de support métallique (2) étant incurvée au moins à certains endroits et au moins une première piste conductrice (4) étant déposée sur la couche diélectrique (3), un matériau diélectrique (23) étant déposé sur l'au moins une piste conductrice (4) à au moins un endroit (22) et au moins une deuxième piste conductrice (4') étant déposée sur la couche diélectrique (3) de façon qu'elle passe au-dessus du matériau diélectrique (23) en croisant, à l'au moins un endroit (22), l'au moins une première piste conductrice (4), en vue de dessus du support de circuit (1), **caractérisé en ce que** le matériau diélectrique pour la couche diélectrique (3) est déposé par pulvérisation thermique et **en ce que** des pistes conductrices (4, 4') et/ou des composants électriques ou électroniques (5) sont déposés dans la zone incurvée.

2. Support de circuit (1), fabriqué selon un procédé selon la revendication 1, avec une couche de support (2) sur laquelle une couche diélectrique (3) est déposée sur certaines zones, la couche de support métallique (2) étant incurvée au moins à certains endroits et des pistes conductrices (4, 4') étant déposées sur la couche diélectrique (3), le support de circuit (1) présentant au moins un endroit (22) auquel, en vu de dessus (22) du support de circuit (1), deux pistes conductrices (4, 4') se croisent, un matériau diélectrique (23), plus particulièrement du verre, étant disposé entre les pistes conductrices (4, 4') qui se croisent, **caractérisé en ce que** la couche électrique (3) est pulvérisée thermiquement et **en ce que**, dans la zone incurvée, des pistes conductrices (4, 4') et/ou des composants (5) électriques ou électroniques sont déposés.

3. Support de circuit selon la revendication 2, **caractérisé en ce que** la couche électrique (3) est un matériau de type céramique, de préférence de l'oxyde d'aluminium (Al₂O₃) ou du nitrure d'aluminium (AIN).
